(19) Europäisches Patentamt
European Patent Office
Office européen des brevets

(11) Veröffentlichungsnummer: **0 304 403**
**A2**

(12) **EUROPÄISCHE PATENTANMELDUNG**

(21) Anmeldenummer: **88810551.7**

(22) Anmeldetag: **12.08.88**

(51) Int. Cl.[4]: **C 08 K 3/00**
C 08 K 3/24, H 01 L 39/12,
G 21 F 1/00

(30) Priorität: **21.08.87 CH 3215/87**

(43) Veröffentlichungstag der Anmeldung:
**22.02.89 Patentblatt 89/08**

(84) Benannte Vertragsstaaten:
**BE CH DE FR GB IT LI NL SE**

(71) Anmelder: **CIBA-GEIGY AG**
**Klybeckstrasse 141**
**CH-4002 Basel (CH)**

(72) Erfinder: **Hilti, Bruno, Dr.**
**Marschalkenstrasse 27**
**CH-4054 Basel (CH)**

**Mayer, Carl W., Dr.**
**Steingrubenweg 224**
**CH-4125 Riehen (CH)**

**Pfeiffer, Jürgen**
**Aumattstrasse 112**
**CH-4153 Reinach (CH)**

**Hofmann, Manfred, Dr.**
**Route Bel-Air 38**
**CH-1723 Marly (CH)**

**Hunziker, Max, Dr.**
**Chasseralstrasse 8**
**CH-3186 Düdingen (CH)**

(54) **Kunststoffzusammensetzung mit Supraleitern.**

(57) Zusammensetzungen aus a) duroplastischen oder thermoplastischen Kunststoffen und Mischungen solcher Kunststoffe und b) einer supraleitenden Verbindung mit einer Sprungtemperatur $T_c$ von mindestens 20 K eignen sich als Formmassen zur Herstellung von Gegenständen für die magnetische Abschirmung von statischen Magnetfeldern und zur Uebertragung von magnetischen bzw. elektrischen Kräften.

EP 0 304 403 A2

**Beschreibung**

**Kunststoffzusammensetzung mit Supraleitern**

Die vorliegende Erfindung betrifft eine Zusammensetzung aus einem Kunststoff und einer supraleitenden Verbindung mit einer Sprungtemperatur von mindestens 20 K.

Supraleiter weisen im supraleitenden Zustand auch einen idealen Diamagnetismus auf (Meissner Effekt, siehe W. Buckel, Supraleitung, Seite 114, Physik Verlag GmbH Weinheim, 1972). Diese Materialien sind daher unter anderem zur Abschirmung magnetischer Felder geeignet. S. Osawa et al. schlagen z.B. supraleitende Filme aus Nb/Ti für diesen Zweck vor [Proc. Int. Cryog. Eng. Conf., 11th, S. 484-488 (1986)]. K. Grohmann et al. beschreiben z.B. Supraleiter in Form von Zylindern für den gleichen Zweck [Cryogenics, 17 (10), S. 579-581 (1977)]. Supraleiter waren bisher aus technischen und wirtschaftlichen Gründen nur beschränkt zur Abschirmung magnetischer Felder verwendbar [siehe Lexikon der Physik, Frankhe-Verlag Stuttgart, Stichwort: magnetische Abschirmung (1969)].

Die Abschirmung statischer und niederfrequenter magnetischer Felder erfordert bisher bei Verwendung von Supraleitern sehr tiefe Temperaturen ($T < 20$ K), oder bei Temperaturen über $\sim 20$ K aufwendige und schwere Panzerungen der zu schützenden Geräte oder Räume mit ferromagnetischen Werkstoffen.

Erst kürzlich wurden Supraleiter mit einer Sprungtemperatur $T_c \geqq 120$ K beschrieben [Superconductor Week 2, 17, 1988]. Die Verwendung solcher Materialien erfordert nur noch Temperaturen, die bei der Temperatur von flüssigem Stickstoff oder darüber liegen.

Supraleitende Materialien werden aus den Ausgangsstoffen im allgemeinen durch Schmelz- und/oder Sinterverfahren hergestellt.

Es wurde gefunden, dass solche zerkleinerten und feinteilige Materialien zwar nicht supraleitend sind, aber unterhalb der Sprunstemperatur immer noch den idealen Diamagnetismus aufweisen. Es wurde ferner gefunden, dass ein hoher Diamagnetismus auch dann noch erhalten bleibt, wenn das feinteilige supraleitende Material in einen Kunststoff eingearbeitet und verteilt wird.

Ein Gegenstand vorliegender Erfindung ist eine Zusammensetzung, enthaltend

a) einen duroplastischen oder thermoplastischen Kunststoff, Mischungen von duroplastischen oder thermoplastischen Kunststoffen, oder Mischungen von duroplastischen und thermoplastischen Kunststoffen, und

b) damit vermischt eine supraleitende Verbindung mit einer Sprungtemperatur $T_c$ von mindestens 20 K.

Geeignete thermoplastische und duroplastische Kunststoffe sind z.B.:

1. Polymere von Mono- und Diolefinen, beispielsweise Polypropylen, Polyisobutylen, Polybuten-1, Polymethylpenten-1, Polyisopren oder Polybutadien sowie Polymerisate von Cycloolefinen wie z.B. von Cyclopenten oder Norbornen; ferner Polyethylen (das gegebenenfalls vernetzt sein kann), z.B. Polyethylen hoher Dichte (HDPE), Polyethylen niederer Dichte (LDPE), lineares Polyethylen niederer Dichte (LLDPE).

2. Mischungen der unter 1) genannten Polymeren, z.B. Mischungen von Polypropylen mit Polyisobutylen, Polypropylen mit Polyethylen (z.B. PP/HDPE, PP/LDPE) und Mischungen verschiedener Polyethylentypen (z.B. LDPE/HDPE und LLDPE/LDPE).

3. Copolymere von Mono- und Diolefinen untereinander oder mit anderen Vinylmonomeren, wie z.B. Ethylen-Propylen-Copolymere, Propylen-Buten-1-Copolymere, Propylen-Isobutylen-Copolymere, Ethylen-Buten-1-Copolymere, Ethylen-Hexen-Copolymere, Ethylen-Methylpenten-Copolymere, Ethylen-Hepten-Copolymere, Ethylen-Octen-Copolymere, Propylen-Butadien-Copolymere, Isobutylen-Isopren-Copolymere, Ethylen-Alkylacrylat-Copolymere, Ethylen- Alkylmethacrylat-Copolymere, Ethylen-Vinylacetat-Copolymere oder Ethylen-Acrylsäure-Copolymere und deren Salze (Ionomere), sowie Terpolymere von Ethylen mit Propylen und einem Dien, wie Butadien, Isopren, Dicyclopentadien oder Ethylidennorbornen; ferner Mischungen solcher Copolymere untereinander und mit unter 1) genannten Polymeren, z.B. Polypropylen/Ethylen-Propylen-Copolymere, LDPE/Ethylen-Vinylacetat-Copolymere, LDPE/Ethylen-Acrylsäure-Copolymere, LLDPE/Ethylen-Vinylacetat-Copolymere und LLDPE/Ethylen-Acrylsäure-Copolymere.

4. Polystyrol, Poly-(p-methylstyrol), Poly-($\alpha$-methylstyrol).

5. Copolymere von Styrol oder $\alpha$-Methylstyrol mit Dienen oder Acrylderivaten und gegebenenfalls Olefinen, wie z.B. Styrol-Butadien, Styrol-Acrylnitril, Styrol-Alkylmethacrylat, Styrol-Butadien-Alkylacrylat, Styrol-Maleinsäureanhydrid, Acrylnitril-Styrol-Acrylsäureester-Copolymer (ASA) wie z.B. Styrol-Acrylnitril-Methylacrylat; Mischungen von hoher Schlagzähigkeit aus Styrol-Copolymeren und einem anderen Polymer, wie z.B. einem Polyacrylat, einem Dien-Polymeren oder einem Ethylen-Propylen-Dien-Terpolymeren, sowie Block-Copolymere des Styrols, wie z.B. Styrol-Butadien-Styrol, Styrol-Isopren-Styrol, Styrol-Ethylen/ Butylen-Styrol oder Styrol-Ethylen/Propylen-Styrol, oder Acrylnitril-Ethylen-Propylen-Styrol (AES).

6. Pfropfcopolymere von Styrol oder $\alpha$-Methylstyrol, wie z.B. Styrol auf Polybutadien, Styrol auf Polybutadien-Styrol- oder Polybutadien-Acrylnitril-Copolymere, Styrol und Acrylnitril (bzw. Methacrylnitril) auf Polybutadien (ABS); Styrol, Acrylnitril und Methylmethacrylat auf Polybutadien; Styrol und Maleinsäureanhydrid auf Polybutadien; Styrol, Acrylnitril und Maleinsäureanhydrid oder Maleinsäureimid auf Polybutadien; Styrol und Maleinsäureimid auf Polybutadien, Styrol und Alkylacrylate bzw.

Alkylmethacrylate auf Polybutadien, Styrol und Acrylnitril auf Ethylen-Propylen-Dien-Terpolymeren, Styrol und Acrylnitril auf Polyalkyl-acrylaten oder Polyalkylmethacrylaten, Styrol und Acrylnitril auf Acrylat-Butadien-Copolymeren, Methacrylsäureester, z.B. Methylmethacrylat und Styrol auf Butadien-Styrol-Kautschuk (MBS) sowie deren Mischungen mit den unter 5) genannten Copolymeren.

6a. Elastomere, die durch Umsetzung, Vernetzung bzw. Vulkanisation von ungesättigten Polymeren erhalten werden können. Ungesättigte Polymere sind durch Polymerisation von Dienen gegebenenfalls zusammen mit olefinischen Comonomeren erhältlich.

7. Halogenhaltige Polymere, wie z.B. Polychloropren, Chlorkautschuk, Fluorkautschuk, chloriertes oder chlorsulfoniertes Polyethylen, Epichlorhydrinhomo- und -copolymere, insbesondere Polymere aus halogenhaltigen Vinylverbindungen, wie z.B. Polyvinylchlorid, Polyvinylidenchlorid, Polyvinylfluorid, Polyvinylidenfluorid; sowie deren Copolymere, wie z.B. Vinylchlorid-Ethylen, Vinylchlorid-Vinylidenchlorid, Vinylchlorid-Vinylacetat oder Vinylidenchlorid-Vinylacetat.

8. Polymere, die sich von α,β-ungesättigten Säuren und deren Derivaten ableiten, wie Polyacrylate und Polymethacrylate, Polyacrylamide und Polyacrylnitrile, sowie Copolymere mit Maleinsäure und/oder Maleinsäureanhydrid.

9. Copolymere der unter 8) genannten Monomeren untereinander oder mit anderen ungesättigten Monomeren, wie z.B. Acrylnitril-Butadien-Copolymere, Acrylnitril-Alkylacrylat-Copolymere, Acrylnitril-Alkoxyalkylacrylat-Copolymere, Acrylnitril-Vinylhalogenid-Copolymere oder Acrylnitril-Alkylmethacrylat-Butadien-Terpolymere.

10. Polymere, die sich von ungesättigten Alkoholen und Aminen bzw. deren Acylderivaten oder Acetalen ableiten, wie Polyvinylalkohol, Polyvinylacetat, -stearat, -benzoat, -maleat, Polyvinylbutyral, Polyallylphthalat, Polyallylmelamin; sowie deren Copolymere mit in Punkt 1 genannten Olefinen.

11. Homo- und Copolymere von cyclischen Ethern, wie Polyalkylenglykole, Polyethylenoxyd, Polypropylenoxyd oder deren Copolymere mit Bisglycidylethern.

12. Polyacetale, wie Polyoxymethylen, sowie solche Polyoxymethylene, die Comonomere, wie z.B. Ethylenoxid, enthalten; Polyacetale, die mit thermoplastischen Polyurethanen, Acrylaten oder MBS modifiziert sind.

13. Polyphenylenoxide und -sulfide und deren Mischungen mit Styrolpolymeren oder Polyamiden.

14. Polyurethane, die sich z.B. von Diolen und/oder Polyethern, Polyestern und polybutadienen mit endständigen Hydroxylgruppen einerseits und aliphatischen oder aromatischen Di- oder Polyisocyanaten andererseits ableiten.

15. Polyamide und Copolyamide, die sich von Diaminen und Dicarbonsäuren und/oder von Aminocarbonsäuren oder den entsprechenden Lactamen ableiten, wie Polyamid 4, Polyamid 6, Polyamid 6/6, 6/10, 6/9, 6/12, 4/6, Polyamid 11, Polyamid 12; Polyamide mit aromatischen Diaminen, z.B. aus m-Xyloldiamin und Adipinsäure; Polyamide, hergestellt aus Hexamethylendiamin und Iso- und/oder Terephthalsäure und gegebenenfalls einem Elastomer als Modifikator, z.B. Poly-2,4,4-trimethylhexamethylenterephthalamid; aromatische Polyamide, z.B. Poly-m-phenylen-isophthalamid; Block-Copolymere der vorstehend genannten Polyamide mit Polyethern, wie z.B. mit Polyethylenglykol, Polypropylenglykol oder Polytetramethylenglykol. Ferner mit EPDM oder ABS modifizierte Polyamide oder Copolyamide; sowie während der Verarbeitung kondensierte Polyamide ("RIM-Polyamidsysteme").

16. Polyharnstoffe aus Diaminen und Diisocyanaten, Polyamidsäuren und deren Salze, Polyimide, Polyamid-imide, Polyetherimide und Polybenzimidazole.

17. Polyester, die sich von Dicarbonsäuren und Dialkoholen und/oder von Hydroxycarbonsäuren oder den entsprechenden Lactonen ableiten, wie Polyethylenterephthalat, Polybutylenterephthalat, Poly-1,4-dimethylolcyclohexanterephthalat, Polyhydroxybenzoate, sowie Block-Polyether-ester, die sich von Polyethern mit Hydroxylendgruppen ableiten; ferner mit Polycarbonaten oder MBS modifizierte Polyester.

18. Polycarbonate und Polyestercarbonate.

19. Polysulfone, Polyethersulfone und Polyetherketone.

20. Polysiloxane die z.B. aus Methyl- oder Methylphenylsiloxanen erhältlich sind, sowie durch Vernetzung hergestellter Silikonkautschuk.

21. Natürliche Polymere, wie Cellulose, Naturkautschuk, Gelatine, sowie deren polymeranalog chemisch abgewandelte Derivate, wie Celluloseacetate, -propionate und -butyrate, bzw. die Celluloseether, wie Methylcellulose, die vernetzten Kautschuke, oder mit Formaldehyd vernetzte Gelatine; sowie Kolophoniumharze und Derivate.

22. Mischungen (Polyblends) der vorgenannten Polymeren, wie z.B. PP/EPDM, Polyamid/EPDM oder ABS, PVC/EVA, PVC/ABS, PVC/MBS, PC/ABS, PBTP/ABS, PC/ASA, PC/PBT, PVC/CPE, PVC/Acrylate, POM/thermoplastisches PUR, PC/thermoplastisches PUR, POM/Acrylat, POM/MBS, PPO/HIPS, PPO/PA 6.6 und Copolymere, PA/HDPE, PA/PP, PA/PPO.

23. Vernetzte Polymere, die sich von Aldehyden einerseits und Phenolen, Harnstoff oder Melamin andererseits ableiten, wie Phenol-Formaldehyd-, Harnstoff-Formaldehyd- und Melamin-Formaldehydharze.

24. Trocknende und nicht-trocknende Alkydharze; Diallylphthalatharze, Furanharze.

25. Ungesättigte Polyesterharze, die sich von Copolyestern gesättigter und ungesättigter Dicarbonsäuren mit mehrwertigen Alkoholen, sowie Vinylverbindungen als Vernetzungsmittel ableiten, wie auch deren halogenhaltige, schwerbrennbare Modifikationen.

26. Vernetzbare Acrylharze, die sich von substituierten Acrylsäureestern ableiten, wie z.B. von Epoxyacrylaten, Urethan-acrylaten oder Polyesteracrylaten.

27. Alkydharze, Polyesterharze und Acrylatharze, die mit Melaminharzen, Harnstoffharzen, Polyisocyanaten oder Epoxidharzen vernetzt sind.

28. Bismaleinimidharze aus aliphatischen oder aromatischen primären Di-oder Polyaminen und Maleinsäureanhydrid, die alleine oder zusammen mit Comonomeren, z.B. mit aliphatischen und/oder aromatischen Di- oder Polyaminen und/oder Di- oder Polyphenolen, Allylphenolglycidylethern oder Allylbisphenolglycidylethern, vernetzt werden können.

29. Vernetzte Epoxidharze aus Epoxidverbindungen mit durchschnittlich mehr als einer, vorzugsweise mindestens 2 Epoxidgruppen im Molekül und Vernetzern oder durch katalysierte Polymerisation zu Polyethern.

Als Epoxidharze kommen vor allem solche mit durchschnittlich mehr als einer an ein Heteroatom (z.B. Schwefel, vorzugsweise Sauerstoff oder Stickstoff) gebundenen Glycidylgruppe, β-Methylglycidylgruppe oder 2,3-Epoxycyclopentylgruppe in Frage; genannt seien insbesondere Bis-(2,3-epoxycyclopentyl)-ether; Di- bzw. Polyglycidylether von mehrwertigen aliphatischen Alkoholen, wie 1,4-Butandiol, oder Polyalkylenglykolen, wie Polypropylenglykole; Di- oder Polyglycidylether von cycloaliphatischen Polyolen, wie 2,2-Bis-(4-hydroxycyclohexyl)-propan; Di- bzw. Polyglycidylether von mehrwertigen Phenolen, wie Resorcin, Bis-(p-hydroxyphenyl)-methan, 2,2-Bis-(p-hydroxyphenyl)-propan (= Diomethan), 2,2-Bis-(4′-hydroxy-3′,5′-dibromphenyl)-propan, 1,1,2,2-Tetrakis-(p-hydroxyphenyl)-ethan, oder von unter sauren Bedingungen erhaltenen Kondensationsprodukten von Phenolen mit Formaldehyd wie Phenol-Novolake und Kresol-Novolake; Di- bzw. Poly-(β-methylglycidyl)-ether der oben angeführten mehrwertigen Alkohole oder mehrwertigen Phenole; Polyglycidylester von mehrwertigen Carbonsäuren, wie Phthalsäure, Terephthalsäure, $\Delta^4$-Tetrahydrophthalsäure und Hexahydrophthalsäure; N-Glycidylderivate von Aminen, Amiden und heterocyclischen Stickstoffbasen, wie N,N-Diglycidylanilin, N,N-Diglycidyltoluidin, N,N,O-Triglycidyl-p-aminophenol, N,N,N′,N′-Tetraglycidyl-bis-(p-aminophenyl)-methan; Triglycidyl-isocyanurat; N,N′-Diglycidylethylenharnstoff, N,N′-Diglycidyl-5,5-dimethylhydantoin, N,N′-Diglycidyl-5-isopropyl-hydantoin, N,N-Methylen-bis-(N′,N′-diglycidyl-5,5-dimethylhydantoin, 1,3-Bis-(N-glycidyl-5,5-dimethylhydantoin)-2-glycidyloxypropan; N,N′-Diglycidyl-5,5-dimethyl-6-isopropyl-5,6-dihydro-uracil; Cycloaliphatische Glycidylether, z.B. Vinylcyclohexendioxid, 3,4-Epoxycyclohexylmethyl-3,4-epoxycyclohexancarboxylat.

Eine bevorzugte Gruppe von Epoxidharzen sind glycidylierte Novolake, Hydantoine, Aminophenole, Bisphenole, aromatische Diamine oder cycloaliphatische Epoxidverbindungen. Besonders bevorzugte Zusammensetzungen enthalten als Epoxidharz einen glycidylierten Kresolnovolak, Bisphenol-A-diglycidylether, mit Bisphenol-A vorverlängerten Bisphenol-A-diglycidylether, Hydantoin-N,N′-bisglycid, Propylen-1,3-bishydantoin-2-hydroxytriglycid, p-Aminophenoltriglycid, Diaminodiphenylmethan-tetraglycid, Vinylcyclohexendioxid, 3,4-Epoxycyclohexylmethyl-3,4-epoxycyclohexancarboxylat oder Mischungen hiervon.

Geeignet sind auch vorreagierte Addukte solcher Epoxide mit Härtern für Epoxide, z.B. das erwähnte Addukt aus Bisphenol-A-diglycidylether und Bisphenol-A, oder mit Oligoestern mit zwei terminalen Carboxylgruppen und Epoxiden vorreagierte Addukte.

Als Härter für Epoxidharze kommen saure oder basische Verbindungen in Frage. Als geeignete Härter seien z.B. genannt: Amine, wie aliphatische, cycloaliphatische oder aromatische, primäre, sekundäre und tertiäre Amine, z.B. Ethylendiamin, Hexamethylendiamin, Trimethylhexamethylendiamin, Diethylentriamin, Triethylentetramin, Tetraethylenpentamin, N,N-Dimethylpropylen-1,3-diamin, N,N-Diethylpropylendiamin-1,3, 2,2-Bis-(4′-aminocyclohexyl)-propan, 3,5,5-Trimethyl-3-(aminomethyl)-cyclohexylamin ("Isophorondiamin"), Mannichbasen, wie 2,4,6-Tris-(dimethylaminomethyl)-phenol; m-Phenylendiamin, p-Phenylendiamin, Bis-(4-aminophenyl)methan, Bis-(4-aminophenyl)-sulfon, m-Xylylendiamin, Aminoalkanole, wie z.B. Aminoethanol, 1,3-Aminopropanol, Diethanolamin oder Triethanolamin; Addukte von Acrylnitril oder Monoepoxiden, wie z.B. Ethylenoxid, Propylenoxid oder Acrylnitril an Polyalkylenpolyamine, wie z.B. Diethylentriamin oder Triethylentetramin; Addukte aus Polyaminen, wie z.B. Diethylentriamin oder Triethylentetramin, im Ueberschuss und Polyepoxiden, wie z.B. Bisphenol-A-diglycidylethern; Polyamide, insbesondere solche aus aliphatischen Polyaminen, wie z.B. Diethylentriamin oder Triethylentetramin, und di- oder trimerisierten ungesättigten Fettsäuren, wie z.B. dimerisierte Leinölfettsäure (VERSAMID®); Dicyandiamid; Polysulfide (THIOKOL®); Anilin-Formaldehyde; mehrwertige Phenole, z.B. Resorcin, 2,2-Bis-(4-hydroxyphenyl)-propan oder Phenol-Formaldehyd-Harze; mehrbasische Carbonsäuren und ihre Anhydride, z.B. Phthalsäureanhydrid, $\Delta^4$-Tetra hydrophthalsäureanhydrid, Hexahydrophthalsäureanhydrid, 4-Methylhexahydrophthalsäureanhydrid, 3,6-Endomethylen-$\Delta^4$-tetrahydrophthalsäureanhydrid, 4-Methyl-3,6-endomethylen-$\Delta^4$-tetrahydrophthalsäureanhydrid (= Methylnadicanhydrid), 3,4,5,6,7,7-Hexachlor-3,6-endomethylen-$\Delta^4$-tetrahydrophthalsäureanhydrid, Bernsteinsäureanhydrid, Adipinsäureanhydrid, Trimethyladipinsäureanhydrid, Azelainsäureanhydrid, Sebacinsäureanhydrid, Maleinsäureanhydrid, Dodecylbernsteinsäureanhydrid; Pyromellitsäuredianhydrid, Trimellitsäureanhydrid, Benzophenontetracarbonsäuredianhydrid oder Gemische solcher Anhydride.

Eine bevorzugte Gruppe von Härtern sind Polyamine, Novolake, Polyaminoamide und Polycarbonsäureanhydride.

Die Epoxidharze können auch zusätzlich mit Härtungsbeschleunigern oder nur mit thermischen Härtungskatalysatoren gehärtet werden. Beispiele sind: tertiäre Amine, deren Salze oder quaternäre Ammoniumverbindungen, z.B. 2,4,6-Tris-(dimethylaminomethyl)phenol, Benzyldimethylamin, 2-Aethyl-4-methylimidazol, Triamylammoniumphenolat, Mono- oder Polyphenole, wie Phenol oder Diomethan oder

Salicylsäure; Bortrifluorid und seine Komplexe mit organischen Verbindungen, wie $BF_3$-Ether-Komplexe und $BF_3$-Amin-Komplexe, z.B. $BF_3$-Monoethylamin-Komplex; Acetoacetanilid-$BF_3$-Komplex; Phosphorsäure; Triphenylphosphit.

Härtungsbeschleuniger und -katalysatoren werden üblicherweise in einer Menge von 0,1-10 Gew.-% zugegeben, bezogen auf das Epoxidharz. Härter für Epoxidharze werden im allgemeinen in äquimolaren Mengen verwendet, bezogen auf die Epoxidgruppen und funktionellen Gruppen eines Härters.

Ein Gegenstand der Erfindung sind auch die zu Duroplasten härtbaren Zusammensetzungen.

Bei den Kunststoffen der erfindungsgemässen Zusammensetzung kann es sich auch um strahlungshärtbare bzw. strahlungsgehärtete Materialien von positiv oder negativ arbeitenden Systemen handeln.

Als strahlungshärtbare Ausgangsstoffe kommen solche von ethylenisch ungesättigten monomeren, oligomeren und polymeren Verbindungen in Frage, die durch Photopolymerisation oder Photodimerisation zu höhermolekularen Produkten reagieren und hierbei ihre Löslichkeit verändern.

Besonders geeignet hierfür sind z.B. Ester und Amide von äthylenisch ungesättigten Carbonsäuren und von Polyolen oder Polyepoxiden bzw. von Polyaminen, und Polymere mit ethylenisch ungesättigten Gruppen in der Kette oder in Seitengruppen wie z.B. ungesättigte Polyester, Polyamide und Polyurethane und Copolymere hiervon, Polybutadien und Polybutadien-Copolymere, Polyisopren und Polyisopren-Copolymere, Polymere und Copolymere mit seitenständigen Maleinimidylgruppen, besonders Dimethylmaleinimidylgruppen oder Acryl- bzw. Methacrylgruppen, ungesättigte Epoxidharze sowie Mischungen von einem oder mehreren solcher Polymeren.

Beispiele für ethylenisch ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind für die Ester aromatische und besonders aliphatische und cycloaliphatische Polyole geeignet. Beispiele für aromatische Polyole sind Hydrochinon, 4,4-Dihydroxyphenylen, Bisphenole wie Bisphenol-A oder -F sowie Novolake und Resole. Geeignete Polyepoxide für die Ester sind z.B. solche auf der Basis der zuvor genannten Polyole, besonders der aromatischen Polyole und Epichlorhydrin. Ferner sind auch Polymere oder Copolymere mit Hydroxylgruppen an der Polymerkette oder in Seitengruppen, wie z.B. Polyvinylalkohol und Copolymere davon oder Polymethacrylsäurehydroxylalkylester wie z.B. β-Hydroxyethylester oder Copolymere davon, als aliphatische Polyole geeignet. Weitere geeignete aliphatische Polyole sind Oligoester mit Hydroxylendgruppen.

Eine bevorzugte Gruppe von aliphatischen oder cycloaliphatischen Polyolen sind solche der Formel $R_n(OH)_n$, worin R ein n-wertiger, vorzugsweise 2-bis 8-, besonders 2- bis 6-wertiger aliphatischer Rest mit 2 bis 30 C-Atomen, der durch Stickstoff-, Schwefel- und besonders Sauerstoffatome sowie Cycloalkylen unterbrochen sein kann, oder Cycloalkylen mit 5 oder 6 Ringkohlenstoffatomen ist. Beispiele für solche Polyole sind Alkylendiole mit bevorzugt 2 bis 12 C-Atomen, wie Ethylenglykol, 1,2- oder 1,3-Propandiol, 1,2-, 1,3-oder 1,4-Butandiol, Pentandiol, Hexandiol, Octandiol, Dodecandiol, Diethylenglykol, Triethylenglykol, Polyethylenglykole mit Molekulargewichten von bevorzugt 100 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ethylenisch ungesättigten Carbonsäuren verestert sein, wobei in Teilestern die freien Hydroxylgruppen modifiziert, z.B. verethert, oder mit anderen Carbonsäuren verestert sein können. Beispiele solcher Ester sind:

Trimethylolpropantriacrylat, Trimethylolethantriacrylat, Trimethylolpropantrimethacrylat, Trimethylolethantrimethacrylat, Tetramethylenglykoldimethacrylat, Triethylenglkoldimethacrylat, Tetraethylenglykoldiacrylat, Pentaerythritdiacrylat, Penterythrittriacrylat, Pentaerythrittetracrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldimethacrylat, 1,3-Butandioldiacrylat, 1,3-Butandioldimethacrylat, 1,4-Butandioldiitaconat, Sorbittriacrylat, Sorbithexaacrylat, Sorbittetramethacrylat, Sorbitpentaacrylat, Sorbithexaacrylat, Oligoesteracrylate, Oligoestermethacrylate, Glycerindi- und -triacrylat, 1,4-Cyclohexandiacrylat, Bis-acrylate und Bismethacrylate von Polyethylenglykol mit einem Molekulargewicht von 100-1500, oder Gemische davon.

Geeignet sind auch die Amide gleicher oder verschiedener ungesättigter Carbonsäuren von aromatischen, cycloaliphatischen und aliphatischen Polyaminen mit bevorzugt 2 bis 6, insbesondere 2 bis 4 Aminogruppen, und 2 bis 30, besonders 2 bis 18 C-Atomen. Beispiele für Amine sind Alkylen diamine mit bevorzugt 2 bis 22 C-Atomen wie Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di(β-aminopropoxy)ethan. Beispiele für solche Amide sind: Methylen-bis-acrylamid, 1,6-Hexamethylenbis-acrylamid, Diethylentriamin-tris-methacrylamid, Bis(methacrylamidopropoxy)-ethan, β-Methacrylamido-ethylmethacrylat, N[(β-hydroxyethyloxy)-ethyl]-acrylamid. Weitere geeignete Polyamine sind Polymere und Copolymere mit Aminogruppen in der Seitenkette und Oligoamide mit Aminoendgruppen.

Geeignete ungesättigte Polyester und Polyamide als strahlungshärtbare Ausgangsstoffe leiten sich z.B. von

Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Strahlungshärtbare Polybutadiene und Polyisoprene und Copolymere davon sind bekannt. Geeignete Comonomere für solche Copolymeren sind z.B. Polyolefine wie Ethylen, Propen, Buten, Hexen, Acrylate und Methacrylate, Acrylnitril, Styrol oder Vinylchlorid. Strahlungshärtbare Polymere mit Maleinimidylgruppen, besonders Dimethylmaleinimidgruppen in Seitenketten sind z.B. in der DE-A 26 26 795 beschrieben. Strahlungshärtbare Polymere mit Acrylat und/oder Methacrylatgruppen in der Seitenkette sind ebenfalls bekannt. Es kann sich z.B. um Umsetzungsprodukte von Epoxidharzen auf Novolakbasis mit Acryl- und/oder Methacrylsäure handeln, um Homo- oder Copolymere des Polyvinylalkohols oder deren Hydroxyalkylderivate, die mit Acryl- und/oder Methacrylsäure verestert sind, oder um Homo- und Copolymere von Hydroxyalkylacrylaten bzw. -methacrylaten, die mit Acryl- bzw. Methacrylsäure verestert sind. Bei den strahlungshärtbaren ungesättigten Epoxidharzen handelt es sich hauptsächlich um solche, die eine

$-HC=CH-\overset{O}{\overset{\|}{C}}-$ oder $-HC=CH-\overset{O}{\overset{\|}{C}}-CH=CH$-Gruppe enthalten. Solche Epoxidharze sind z.B. in der DE-A 23 42 407 beschrieben.

Die strahlungshärtbaren Ausgangsstoffe können alleine oder in beliebigen Mischungen eingesetzt werden. Vorteilhaft ist das Zumischen von Estern ungesättigter Carbonsäuren, besonders der Acrylate bzw. Methacrylate von Polyolen, und/oder weiteren Vinylverbindungen wie z.B. Vinylpyridin oder Vinylpyrrolidon.

Weitere geeignete strahlungshärtbare Ausgangsstoffe sind z.B. auch kationisch polymerisierbare organische Materialien, in Gegenwart von strahlungsaktivierbaren latenten Härtern, z.B. Epoxidharze ohne C=C-Doppelbindungen, besonders Epoxidharze auf Basis aromatischer Polyole. Beispiele für solche latente Härter sind α- und β-Acylsulfonyloxyverbindungen, Diazoniumsalze, Oniumsalze der Elemente der Gruppen Va, VIa oder VIIa der Periodensystems, z.B. die Chloride, Bromide, Jodide und besonders die Salze von Komplexsäuren wie z.B. Hexafluorophosphat und Hexafluoroarsenat; N-Sulfonyloxyimide; Ester von Sulfonsäuren mit β-Methylolbenzoinen und o-Hydroxyacylphenonen; o-Nitrobenzaldehyde und α-Chlor- oder α-Bromacylphenone. Unter den Oniumsalzen sind die Sulfoniumsalze und Jodoniumsalze wie z.B. Triphenylsulfoniumhexafluorophosphat oder Diphenyljodoniumhexafluorophosphat bevorzugt. Geeignete latente Härter sind auch Cyclopentadienyleisenarensalze, wie z.B. ($\eta^6$-Methylnaphthalin)-($\eta^5$-cyclopentadienyl)eisen-II-hexafluorophosphat. Solche Salze sind z.B. in der EP-B- 0 094 915 beschrieben. Arencarbonyl- bzw. Dienylcarbonylmetallsalze als latente Härter sind in der EP-B-0 094 914 beschrieben.

Geeignete strahlungshärtbare Ausgangsstoffe sind auch Oligomere und Polymere, z.B. Polyimide, die Polyazide als Vernetzungsmittel enthalten, siehe z.B. EP-B-0 092 524.

Bevorzugt enthält die Zusammensetzung ein strahlungsgehärtetes Epoxidacrylat oder Epoxidmethacrylat, Epoxidharz, Polyesteracrylat oder -methacrylat auf Bisphenolbasis, oder ein Polymer mit seitenständigen Maleinimidylgruppen, besonders Dimethylmaleinimidgruppen.

Den strahlungshärtbaren Materialien können auch Bindemittel zugesetzt werden, was besonders zweckmässig ist, wenn es sich bei den strahlungshärtbaren Ausgangsstoffen um flüssige oder viskose Substanzen handelt.

Geeignete Bindemittel sind z.B. Polymere mit einem Molekulargewicht von etwa 5 000 bis 2 000 000, bevorzugt 10 000 bis 1 000 000. Beispiele sind: Homo- und copolymere Acrylate und Methacrylate, z.B. Copolymere aus Methylmethacrylat, Ethylacrylat und Methacrylsäure, Poly(methacrylsäurealkylester), Poly(acrylsäurealkylester), wobei Alkyl = $C_1$-$C_{20}$ ist, Celluloseester und -ether wie Celluloseacetat, Celluloseacetatbutyrat, Methylcellulose, Ethylcellulose, Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere aus vinylidenchlorid mit Acrylonitril, Methylmethacrylat und Vinylacetat, Polyvinylacetat, Copoly(ethylen/vinylacetat), Polyamide wie Poly(hexamethylenadipamid) und Polycaprolactam, Polyester wie Poly(ethylenglykolterephthalat) und Poly(hexamethylenglykolsuccinat).

Zur Erhöhung der Lichtempfindlichkeit können den strahlungsempfindlichen Materialien Initiatoren und Sensibilisatoren zugesetzt werden, wie aromatische Ketone, z.B. Tetramethyldiaminobenzophenon, Benzophenon, Michler's Keton (4',4-Bis-(dimethylamino)benzophenon), 4,4'-Bis(diethylamino)benzophenon, 4-Acryloxy-4'-diethylaminobenzophenon, 4-Methoxy-4'-dimethylaminobenzophenon, 2-Ethylanthrachinon, Phenantrachinon, 2,6-Butylanthrachinon, 1,2-Benzanthrachinon, 2,3-Benzanthrachinon, 2,3-Dichlornaphthochinon, Benzildimethylketal und aromatische Ketone gemäss US-Patent 3,552,973; Benzoin, Benzoinether, wie Benzoinmethylether, Benzoinethylether, Benzoinisobutylether und Benzoinphenylether, Methylbenzoin, Ethylbenzoin und andere Benzoine, p-Maleinimidobenzolsulfonsäureazid, Thioxanthonderivate, wie Thioxanthon, 2-Chlorthioxanthon, 2-Isopropylthioxanthon, Thioxanthon-1-carbonsäureethylester, 3-Methoxythioxanthon-1-carbonsäureethylester in Verbindung mit aromatischen Aminen, wie p-Dimethylaminobenzoesäureethylester und 4,4'-Bis(dimethyl amino)-benzophenon, Titanocene, wie z.B. in den EP-A-0 122 223 und EP-A-0 186 626 beschrieben sind. Solche Initiatoren und Sensibilisatoren werden im allgemeinen in Mengen von 0,1 - 10 Gew.% verwendet.

Ein weiteres geeignetes strahlungsempfindliches Material sind Polymere, die Imidstruktureinheiten aus Di- oder Tetracarbonsäuren mit mindestens einer Benzophenonstruktureinheit und Aminreste enthalten, wobei aromatische Aminreste in mindestens einer Orthostellung zum Imid-N-Atom mit $C_1$-$C_{12}$-Alkyl, besonders Methyl, Ethyl oder Propyl substituiert sind. Bevorzugt sind Polyimide und entsprechende Amidsäuren oder Amidsäureester mit aliphatischen Alkoholen. Die Polymeren und Polyimide sind z.B. beschrieben in den veröffentlichten europäischen Patentanmeldungen 0 134 752, 0 138 768, 0 132 221, 0 162 017, 0 181 837, 0 182 745, 0 203 030, 0 198 798 und 0 200 680.

Geeignet sind auch Thiol-en-Systeme, z.B. Polythiole mit ungesättigten Polymeren, wie Ester von Thioglycolsäure oder β-Mercaptopropionsäure und Polyolen mit Polybutadien oder Polyisopren;

Als Beispiel für einen Positivresist seien die Ester von Naphthachinonazidsulfonsäuren und aromatischen Polyolen, z.B. Novolaken, genannt.

Die Härtung der strahlungsempfindlichen Ausgangsstoffe kann durch γ-Strahlung, Röntgenstrahlung, Elektronenstrahlung, Laserlicht und sichtbarem Licht bis UV-Strahlung vorgenommen werden.

In einer Ausführungsform der erfindungsgemässen Zusammensetzung kann der Kunststoff auch ein Klebstoff sein.

Eine bevorzugte Gruppe von thermoplastischen Kunststoffen sind Homo-oder Copolymere von Mono- oder Diolefinen; Homo-, Co- und Propfpolymere von Styrolen; halogenhaltige Polymere; Homo- und Copolymere von α,β-ungestättigten Carbonsäuren und deren Derivate, Homo- und Copolymere von ungesättigten Alkoholen und Aminen; Homo-und Copolymere von cyclischen Ethern; Polyacetale, Polyphenylenoxide oder -sulfide; Polyurethane; Polyamide; Polyharnstoffe; Polyimide; Polybenzimidazole; Polyester; Polycarbonate und Polyestercarbonate; Polysulfone; Polyethersulfone; Polyetherketone; Cellulose oder -derivate.

Eine besonders bevorzugte Gruppe der Duroplaste sind vernetzte Epoxidharze, vernetzte Additionssysteme auf Isocyanatbasis, ungesättigte Polyesterharze, Bismaleinimidharze, Phenol-Formaldehyd-, Harnstoff-Formaldehyd- und Melaminformaldehydharze.

Die supraleitende Verbindung weist vorteilhaft eine Sprungtemperatur $T_c$ von mindestens 50 K, besonders mindestens 80 K auf.

Supraleiter mit einer Sprungtemperatur $T_c$ von > >20 K sind in letzter Zeit bekannt geworden, siehe z.B. Phys. Rev. Let., 58, S. 1676-1697 (1987), Phys. Rev. Let. 58, S. 1888-1890 (1987) und Phys. Rev. Let. 58, S. 2579-2581 (1987). In der letzten Publikation sind Hinweise für Phasen mit einer Sprungtemperatur oberhalb Raumtemperatur gegeben. Die obere Grenze der Sprungtemperatur ist für die Erfindung nicht wesentlich.

Die erfindungsgemässe Zusammensetzung kann bis zu 90 Gew.-% der supraleitenden Verbindung enthalten. Bevorzugt enthält die Zusammensetzung 10 bis 80, besonders 10 bis 70 und insbesondere 10 bis 60 Gew.-% Kunststoff (a) und 90 bis 20, besonders 90 bis 30 und insbesondere 90 bis 40 Gew.-% der supraleitenden Verbindung (b).

Die erfindungsgemässe Zusammensetzung kann auch Füllstoffe und/oder Verstärkerfüllstoffe enthalten, wobei die Menge zusammen mit der supraleitenden Verbindung höchstens 90 Gew.-% ausmacht, bezogen auf die Zusammensetzung. Solche Füllstoffe werden üblicherweise in Mengen von 5 bis 60, vorzugsweise 10 bis 40 Gew.-% einverleibt. Bei strahlungshärtbaren Materialien kann die Menge geringer sein, um die Lichtempfindlichkeit zu gewährleisten.

Die in der Zusammensetzung verwendeten Supraleiter werden im allgemeinen durch einen thermischen Sinter- oder Schmelzprozess hergestellt. Die so hergestellten supraleitenden Verbindungen können leicht zu einem bevor zugt zu verwendenden feinteiligen Material vermahlen werden. Die mittlere Partikelgrösse kann z.B. bis zu 500 µm, bevorzugt 0,1 bis 200 µm, besonders 1 bis 100 µm und insbesondere 1 bis 50 µm betragen.

In einer bevorzugten Ausführungsform handelt es sich bei der supraleitenden Verbindung um ein Cuprat mit $K_2NiF_4$-Struktur der Formel I

$La_{2-x}M_xCuO_{4-\delta}$ (I),

worin M für Ca, Ba oder Sr steht und x zwischen 0,05 und 1,1, besonders 0,2 ist. Der Wert für δ is noch nicht bestimmt, ergibt sich aber aus den Herstellverfahren [Phys. Rev. Lett. 58, 405 bis 408 (1987)]. Beispiele sind $La_{1,8}Ba_{0,2}CuO_{4-\delta}$, $La_{1,8}Ca_{0,2}CuO_{4-\delta}$ oder $La_{1,8}Sr_{0,2}CuO_{4-\delta}$.

In einer anderen Ausführungsform kann es sich bei der supraleitenden Verbindung um einen Kupferperowskit mit Sauerstoffmangel handeln, der Ba, das teilweise durch Ca oder Sr ersetzt sein kann, und ein oder mehrere Seltene Erdmetalle enthält. Die Seltenen Erdmetalle sind bevorzugt aus der Gruppe Y, Eu, La, Sc und Pr ausgewählt [Phys. Rev. Lett. 18, S. 1888-1890 (1987)]. Diese supraleitenden Verbindungen können der Formel II entsprechen,

$M_3Cu_3O_x$ (II),

worin x eine Zahl von 6,7-7,3, bevorzugt 6,85 ist und $M_3$ eine Kombination von Erdalkalimetallen und Seltene Erdmetalle darstellt, z.B.$Ba_2Y$, $Ba_2Eu$, $Ba_2La$, $Ba_{1,8}La_{1,2}$, BaCaLa, BaCaY, $Ba_2Y_{0,75}Sc_{0,25}$, $Ba_2Eu_{0,75}Sc_{0,25}$, $Ba_2Y_{0,5}La_{0,5}$, $Ba_{1,5}Sr_{0,5}Y$, $Ba_2Eu_{0,9}Pr_{0,1}$, $Ba_2Eu_{0,9}Y_{0,1}$ oder $Ba_2Eu_{0,75}Y_{0,25}$ bedeutet.

Ferner kann es sich bei der supraleitenden Verbindung um $Ba_2YCu_3F_2O_y$ handeln [Phys. Rev. Lett, 24, S. 2579-2581 (1987)]. Der Wert für y ist nicht definiert und ergibt sich aus dem beschriebenen Herstellverfahren. Danach ist der Wert für y so, dass sich ein $T_c \geqq$ 155 K einstellt.

Neuerdings sind weitere Hochtemperatur-Supraleiter-Verbindungen bekanntgeworden wie z.B.

$Ba_{0,6}K_{0,4}BiO_3$ mit einer Sprungtemperatur $T_c = 30$ K (R.J. Cava et al.: Nature, Vol. 332, p. 814 (1988)), $Bi_2Sr_2CaCu_2O_8$ mit einer Sprungtemperatur $T_c = 85$ K (H.W. Zandbergen et al.: Nature, Vol. 332, p. 620 (1988)), $BiSrCaCu_2O_x$ mit einer Sprungtemperatur $T_c = 110$ K (H. Maeda et al.: Jap. J. appl. Phys. Lett. 27 (im Druck), Zitat aus Nature 332, p. 623 (1988)), Bi-Al-Ca-Sr-Cu-O-Multiphasen Systeme mit einer Sprungtemperatur $T_c = 114$ K (C.W. Chu et al.: Physical Review Letters 60, 10, p. 941 (1988)), $Tl_1Ca_2Ba_2Cu_3O_x$ mit einer Sprungtemperatur $T_c = 110$ K, $Tl_2Ca_2Ba_2Cu_3O_x$ mit einer Sprungtemperatur $T_c = 125$ K (Superconductor Week 2, 14, 1988) und $Tl_2Ba_2CaCu_2O_8$ mit einer Sprungtemperatur $T_c \simeq 120$ K (M.A. Subramanian et al.: Nature, Vol. 332, p. 420 (1988)).

Die Herstellung der erfindungsgemässen Zusammensetzungen kann nach bekannten Verfahren durch Vermischen der Komponenten erfolgen, z.B. vor oder während der Kunststoffherstellung oder vor oder während der Formgebung. Hierbei können den Kunststoffen weitere die Verarbeitung und/oder die Eigenschaften verbessernde bzw. beeinflussende Zusätze einverleibt werden. Beispiele sind Formtrennmittel, Verlaufmittel, Flussmittel, Weichmacher, Flammhemmer, Antistatika, Gleitmittel, Farbstoffe, Pigmente, Anitoxidantien, Lichtschutzmittel, Stabilisatoren und Füllstoffe, z.B. Metalloxide ($SiO_2$, $Al_2O_3$), Metallcarbonate und -sulfate ($CaCO_3$, $MgCO_3$, $BaSO_4$), Glaspulver oder -kugeln, Silikate (Talk, Kaolin, Wollastonit, Bentonit), Graphit, Russ, faserförmige Verstärkerfüllstoffe, z.B. Kunststoffasern, Kohlenstofffasern und Glasfasern, ferner metallhaltige Füllstoffe, Füllstoffe mit Halbleitereigenschaften, thermisch leitende Füllstoffe, Dielektrika, Ferroelektrika, Füllstoffe mit magnetischen, piezoelektrischen und elektrochromen Eigenschaften und Phosphoren, wie sie z.B. in der EP-A-0 182 744 beschrieben sind.

Die erfindungsgemässen Zusammensetzungen eignen sich als Formmassen zur Herstellung von geformten Gegenständen in beliebigen Formen, wie z.B. Fasern, Fäden, Folien, Beschichtungen, Platten, Halbzeug und Formteilen aller Art. Die strahlungshärtbaren Zusammensetzungen eignen sich zur Herstellung von Beschichtungen oder Reliefabbildungen auf Substraten aller Art. Strahlungsgehärtete Beschichtungen können vom Substrat gelöst und als Folien verwendet werden.Ein weiterer Gegenstand der Erfindung sind geformte Gegenstände aus den erfindungsgemässen Zusammensetzungen.

Die Herstellung der geformten Gegenstände kann nach bekannten Verfahren für die Verarbeitung von Kunststoffen erfolgen, z.B. durch Giessen, Beschichten, Laminieren (Tränk- und Wickelverfahren), Pressen, Spritzpressen, Kalandrieren, Tiefziehen, Extrudieren und Spritzgiessen.

Die erfindungsgemässen Formteile weisen gute mechanische Stabilitäten und einen hohen Diamagnetismus, aber keine Supraleitfähigkeit auf, so dass selbst dünnwandige Formteile statische und niederfrequente Magnetfelder gut abzuschirmen vermögen. Die Formteile stellen somit leichte Bauteile oder Fertigteile für die wirtschaftliche Herstellung von Formen zur Abschirmung magnetischer Felder bei technisch leicht erreichbaren Temperaturen dar, z.B. Gehäuse für Magneten oder elektronische Geräte. Ferner eignen sich die Zusammensetzungen zur Herstellung von Bauteilen zur Uebertragung von elektrischen bzw. magnetischen Kräften.

Ein weiterer Gegenstand der Erfindung ist die Verwendung der erfindungsgemässen Zusammensetzung zur Herstellung geformter Gegenstände für die Abschirmung von Magnetfeldern und zur Uebertragung von elektrischen bzw. magnetischen Kräften.

Die strahlungsgehärteten Zusammensetzungen können nach in der Technik für solche Materialien bekannten Verfahren verarbeitet werden.

Sie werden üblicherweise in Form von Lösungen in organischen Lösungsmitteln auf geeignete Trägermaterialien, wie Kunststoffe, z.B. Polyesterfolien, Holz, Papier, Metalle, Metallegierungen, Halbmetalle, Halbleiter, Glasplatten, Keramik, Verbundwerkstoffe, Laminate wie z.B. kupferkaschierte Epoxylaminate, $SiO_2$ oder $Si_3N_4$, appliziert. Als organische Lösungsmittel eignen sich z.B. polare, besonders polare aprotische Lösungsmittel, die einzeln oder in Mischungen verwendet werden können. Beispiele solcher Lösungsmittel sind: Alkohole, wie Methanol, Ethanol und Diacetonalkohol; N-substituierte Amide aliphatischer Monocarbonsäuren, wie N,N-Dimethylformamid und N,N-Dimethylacetamid; Ether, wie Diethylether, Di-n-butylether, Tetrahydrofuran, Dioxan, 2-Methoxyethanol, 1,2-Dimethoxyethan, Diethylenglykoldimethylether, Diethylenglykoldiethylether, Diethylenglykolmono-n-butylether, Triethylenglykoldimethylether; halogenierte Kohlenwasserstoffe, wie Methylenchlorid, Chloroform, Tetrachlorkohlenstoff, 1,2-Dichlorethan, 1,1,2-Trichlorethan, 1,1,2,2-Tetrachlorethan; Carbonsäureester und Lactone, wie Propylencarbonat, Essigsäureethylester, Propionsäuremethylester, Benzoesäureethylester, 1-Acetoxy-2-ethoxyethan, 1-Acetoxy-2-methoxyethan, $\gamma$-Butyrolacton und $\gamma$-Valerolacton; Sulfoxide, wie Dimethylsulfoxid und Tetramethylsulfoxid; Sulfone, wie Dimethylsulfon, Diethylsulfon, Trimethylensulfon, Tetramethylensulfon; Ketone, wie Dimethylketon, Methylethylketon, Methylisobutylketon und Cyclohexanon; substituierte Benzole, wie Chlorbenzol und Nitrobenzol. Bevorzugte Lösungsmittel sind Carbonsäureester und Ketone, wie 2-Acetoxy-2-ethoxyethan und Cyclohexanon.

Die Lösungen werden mittels üblicher Verfahren auf das Trägermaterial aufgebracht, z.B. durch Tauchen, Streichen, Sprühen, Aufstempeln, Aufschleudern oder durch Walzenauftrag.

Die erfindungsgemässen strahlungshärtbaren Zusammensetzungen können auch trocken appliziert werden, z.B. mittels Pulverbeschichtung.

Die Trockenschichtdicken liegen im allgemeinen je nach Verwendungszweck im Bereich von etwa 0,5 bis 200 $\mu$m, bevorzugt 5 bis 100 $\mu$m. Nach dem Beschichten wird gegebenenfalls vorhandenes Lösungsmittel auf

übliche Weise entfernt, z.B. durch Erwärmen und gegebenenfalls zusätzlich im Vakuum.

Es ist auch möglich, mit den erfindungsgemässen Zusammensetzungen erhaltene Beschichtungen vor der weiteren Behandlung auf andere Substrate zu übertragen. So können z.B. auf Kunststoffolien hergestellte Filme nach dem Trocknen mittels eines Rollenlaminators auf andere Substrate, wie Glas- oder Keramikplatten, Monel®-Substrate (Ni-Cu-Legierungen) und Tombak-Substrate (Cu-Zn-Legierungen), z.B. versilberte oder vergoldete Tombak- und Monelsubstrate, übertragen werden.

Die Härtung der erfindungsgemässen Zusammensetzungen bzw. der damit erhaltenen Beschichtungen kann einstufig durch Photohärtung, gegebenenfalls bei erhöhten Temperaturen, z.B. zwischen 80 und 130°C, vorgenommen werden. Sie wird jedoch zweckmässig zweistufig, d.h. durch Photohärtung, gefolgt von einer thermischen Nachhärtung bei z.B. 50 bis 150°C, durchgeführt, wenn es sich bei dem strahlungshärtbaren Material um ein kationisch polymerisierbares Material handelt und insbesondere Photoinitiatoren aus der Gruppe der Cyclopentadienyleisenarensalze verwendet werden (siehe EP-A-0 132 744). Die Photohärtung wird zweckmässig mit sichtbarem bis UV-Licht bei einer Wellenlänge von 200-600 nm und mit Lichtquellen eine Leistung von 150-8000 Watt, vorzugsweise bei 1000-5000 Watt, vorgenommen. Als Lichtquellen eignen sich beispielsweise Xenonlampen, Argonlampen, Wolframlampen, Kohlelichtbögen, Metallhalogenid- und Metall-Lichtbogenlampen, wie Niederdruck-, Mitteldruck- und Hochdruckquecksilberlampen, Argonionen-Laser, frequenzverdoppelte Nd-YAG-Laser (yttrium-aluminium garnet), UV-Laser oder VIS-Laser.

Die Bestrahlungszeit hängt von verschiedenen Faktoren ab, z.B. der Schichtdicke der erfindungsgemässen Zusammensetzung, der Art der Lichtquelle und deren Abstand von der zu belichtenden Schicht sowie der Art und der Menge der verwendeten supraleitenden Verbindungen und gegebenenfalls weiteren Füllstoffen. Im allgemeinen liegt die Bestrahlungszeit zwischen 1 Sekunde und 600 Sekunden.

Bei einer flächenmässigen Belichtung erhält man beschichtete Substrate, die wie zuvor erwähnt als Bauteile für magnetische Abschirmungen bzw. Formkörper zur Kraftübertragung elektrischer bzw. magnetischer Kräfte verwendet werden können. Die Beschichtungen können auch direkt zur Abschirmung von elektronischen und mikroelektronischen Bauteilen und Schaltelementen, Kontakten und Leiterbahnen dienen.

Die Bestrahlung (Belichtung) kann auch unter einer Photomaske vorgenommen werden.

Nach dem Belichten und gegebenenfalls der thermischen Härtung werden die nicht belichteten Bildstellen durch Behandlung mit einem Lösungsmittel oder Lösungsmittelgemisch entwickelt. Geeignete Lösungsmittel sind z.B. solche der oben erwähnten Art. Auf diese Weise erhält man Reliefabbildungen bis zu Mikrogrösse, die insbesondere auf den Gebieten der Hochfre quenztechnik, Elektronik, Mikroelektronik und Optoelektronik Anwendung finden. Mit diesem Verfahren können magnetische Abschirmungen kleinster Abmessungen erzielt werden.

Ein weiterer Gegenstand der Erfindung ist die Verwendung der strahlungshärtbaren erfindungsgemässen Zusammensetzung zum Erzeugen von Beschichtungen, Reliefabbildungen oder Verklebungen mittels Strahlungshärtung und gegebenenfalls thermischer Nachhärtung.

Beschichtungen aus der erfindungsgemässen Zusammensetzung und Reliefabbildungen auf thermisch beständigen Substraten können thermisch bei z.B. 250 bis 1000°C behandelt werden, wobei das Bindemittel (Thermoplast, Duroplast einschliesslich strahlungsgehärteter Kunststoffe) abgebaut und verflüchtigt wird. Die zurückbleibende supraleitende Verbindung kann dann noch nachgetempert bzw. gesintert werden, z.B. unter Inertgas, Luft, $O_2$-, $N_2$- oder $H_2$-Atmosphäre.

Auf diese Weise können Schichten, Leiterbahnen und Leitermuster aus supraleitenden Verbindungen bis zu kleinsten Dimensionen hergestellt werden, die z.B. als gedruckte Schaltungen zur elektrischen Verbindung von elektronischen Bauteilen, als Dickschichtschaltungen, oder zur Kontaktierung für integrierte Schaltungen verwendet werden können.

Die nachfolgenden Beispiele erläutern die Erfindung näher.

Beispiel 1:

1 g fein pulverisiertes $YBa_2Cu_3O_{6,9}$, hergestellt nach der Vorschrift in Phys. Rev. Let., 58, S. 1676 (1987), und 1 g Epoxidharz auf Basis von festem und flüssigem Bisphenol-A mit einem EP-Wert von 4,35 mit Dimethylaminopropylaminopropylamin beschleunigtes Polyaminoamid als Härter werden während 1 Minute innig vermischt. Diese Mischung wird 1 Stunde im Vakuum (18,5 mbar) entgast. Mit einem Ziehdreieck werden daraus Platten der Grösse 100x30x0,2 mm hergestellt und 12 Stunden bei 30°C gehärtet. Diese mit flüssigem Stickstoff gekühlten Proben (T ~90 K) schweben über einer Magnetplatte, was den hohen Diamagnetismus anzeigt.

Beispiel 2: Herstellung einer Struktur mit Hilfe von Photopolymeren:

Photopolymer-Formulierung
30 g Bisphenol-A-Acrylatoligomer (Chemlink® 3000, Sartomer Company, USA)
7,5 g 1,6-Hexandioldiacrylat (SR 238, Sartomer Company, USA)
9 g Trimethylolpropantriacrylat (SR 351, Sartomer Company, USA)
2,5 g Benzildimethylketal
0,5 g Isopropylthioxanthon (Ward Blenkinsop Co., UK)

49,5 g Methylisobutylketon.

10 g des obigen Gemisches werden mit 15 g Y $Ba_2Cu_3O_{7-x}$ gemischt und homogenisiert. Dann gibt man einige g dieses Gemisches in eine flache Schale und schreibt mit dem Strahl eines Argonionen-Lasers bei 351-364 nm ein Muster in das Gemisch. An den belichteten Stellen vernetzt das Polymer-/Oxidgemisch und wird unlöslich. Das belichtete Muster entfernt man mit einer Pinzette aus dem flüssigen Polymergemisch, wäscht mit Aceton nach, transferiert die Struktur auf ein Platinblech, tempert anschliessend während 5 Stunden bei 920° C und lässt über Nacht langsam abkühlen. Die so erhaltene Oxid-Struktur in der Form des belichteten Musters zeigt bei der Temperatur des flüssigen Stickstoffs den Meissner-Effekt (Diamagnetismus).

Beispiel 3:

Beliebige geometrische Strukturen können nach grundsätzlich bekannten photolithographischen Verfahren hergestellt werden. Dazu wird eine dickflüssige Polymerlösung aus einem Epoxy-Cresol-Novolak (ECN 1299, Ciba-Geigy) 60 % in 1-Acetoxy-2-Ethoxy-Ethan zubereitet. Davon getrennt werden 66 mg eines Eisen-Aren-Komplexes der Formel III in 0,5 g 1-Acetoxy-2-Ethoxy-Ethan und 2 Tropfen Dimethyl-Formamid gelöst. Das supraleitende Mischoxid $YBa_2Cu_3O_{6,9}$ (Typ 1230 S, Korngrösse 1 µm, von Furu'uchi Chemicals, Japan) wird während 5 Stunden bei 950° C getempert und anschliessend in einem Achatmörser während 10 Minuten zerkleinert. 9,4 g des gemahlenen Mischoxides wird mit 3,3 g der Polymerlösung und 4 g 1-Acetoxy-2-Ethoxy-Ethan auf einem Magnetrührer gut vermischt, dann wird unter weiterem Rühren die Lösung des Eisen-Aren-Komplexes unter Ausschluss von Tageslicht beigegeben. Alle folgenden Arbeiten bis zur Entwicklung werden ebenfalls unter Gelblicht ausgeführt.

Mit einem Ziehstab für 100 µm Nassfilmdicke wird die oben beschriebene Paste auf eine Polyester-Trägerfolie von 40 µm Dicke aufgetragen und anschliessend in einem Wärmeschrank während 15 Minuten bei 80° C getrocknet. Für die Kontakt-Belichtung wird eine Maske mit dem gewünschten Muster auf die Folie gelegt und während 30 Minuten mit einer 2000 W Metall-Halogen-Lampe (OC HELIOPRINT) belichtet. Der belichtete Film wird während 3 Minuten bei 110° C im Trockenschrank nachgehärtet und anschliessend in einem Lösungsmittelbad (I-Acetoxy-2-Ethoxy-Ethan) während 5 Sekunden entwickelt, dann mit einem Lösungsmittel-getränkten Wattebausch abgewischt.

Die entwickelten Strukturen haben den starken Diamagnetismus des eingebauten Mischoxides, was durch das Schweben von kleinen Folienstücken über einem Permanentmagneten bei der Temperatur des flüssigen Stickstoffes überprüft wird.

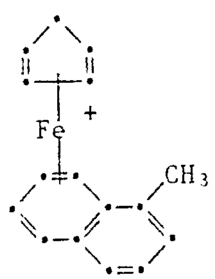

$SbF_6^-$ (III)

**Patentansprüche**

1. Zusammensetzung, enthaltend
   a) einen duroplastischen oder thermoplastischen Kunststoff, Mischungen von duroplastischen oder thermoplastischen Kunststoffen, oder Mischungen von duroplastischen und thermoplastischen Kunststoffen, und
   b) damit vermischt eine supraleitende Verbindung mit einer Sprungtemperatur $T_c$ von mindestens 20 K.

2. Zusammensetzung gemäss Anspruch 1, dadurch gekennzeichnet, dass es sich bei der Komponente a) um einen duroplastischen Kunststoff handelt.

3. Zusammensetzung gemäss Anspruch 2, dadurch gekennzeichnet, dass es sich bei dem duroplastischen Kunststoff um ein vernetztes Epoxidharz, ein vernetztes Additionssystem auf Isocyanatbasis, ungesättigtes Polyesterharz, Bismaleinimidharz, Phenol-Formaldehyd, Harnstoff-Formaldehyd oder Melamin-Formaldehydharz handelt.

4. Zusammensetzung gemäss Anspruch 3, dadurch gekennzeichnet, dass es sich bei dem Epoxidharz um ein solches auf der Basis von glycidylierten Novolaken, Hydantoinen, Aminophenolen, Bisphenolen, aromatischen Diaminen oder um cycloaliphatischen Epoxiden handelt.

5. Zusammensetzung gemäss Anspruch 4, dadurch gekennzeichnet, dass es sich um ein Epoxidharz auf der Basis glycidylierter Kresolnovolake; Bisphenol-A-diglycidylether; mit Bisphenol-A vorverlängerter Bisphenol-A-diglycidylether; 5,5-Dimethylhydantoin-N,N′-bisglycid, 1,3-Bis(N,N′-diglycidyl-5,5-dimethylhydanto-4-yl)-2-glycidoxypropan, p-Aminophenoltriglycid, Diaminodiphenylmethantetraglycid, Vinylcyclohexendioxid, 3,4-Epoxycyclohexylmethyl-3,4-epoxycyclohexancarboxylat oder Mischungen hiervon handelt.

6. Zusammensetzung gemäss Anspruch 3, dadurch gekennzeichnet, dass das Epoxidharz als Härtungskomponente ein Polyamin, einen Novolak, ein Polyaminoamid oder ein Polycarbonsäureanhydrid enthält.

7. Zusammensetzung gemäss Anspruch 1, dadurch gekennzeichnet, dass es sich bei dem thermoplastischen Kunststoff um Homo-oder Copolymere von Mono- oder Diolefinen; Homo-, Co- und Propfpolymere von Styrolen; halogenhaltige Polymere; Homo- und Copolymere von $\alpha,\beta$-ungestättigten Carbonsäuren und deren Derivate; Homo- und Copolymere von ungesättigten Alkoholen und Aminen, Homo- und Copolymere von cyclischen Ethern; Polyacetale, Polyphenylenoxide oder -sulfide, Polyurethane; Polyamide; Polyharnstoffe; Polyimide; Polybenzimidazole; Polyester; Polycarbonate und Polyestercarbonate; Polysulfone; Polyethersulfone; Polyetherketone; Cellulose oder -derivate handelt.

8. Zusammensetzung gemäss Anspruch 1, dadurch gekennzeichnet, dass der Kunststoff ein strahlungshärtbares oder strahlungsgehärtetes Material ist.

9. Zusammensetzung gemäss Anspruch 1, dadurch gekennzeichnet, dass die Sprungtemperatur $T_c$ mindestens 50 K beträgt.

10. Zusammensetzung gemäss Anspruch 1, dadurch gekennzeichnet, dass die Sprungtemperatur $T_c$ mindestens 80 K beträgt.

11. Zusammensetzung gemäss Anspruch 1, dadurch gekennzeichnet, dass 10 bis 80 Gew.-% Kunststoff (a) und 90 bis 20 Gew.-% der supraleitenden Verbindung (b) enthalten sind.

12. Zusammensetzung gemäss Anspruch 11, dadurch gekennzeichnet, dass 10 bis 70 Gew.-% (a) und 90 bis 30 Gew.-% (b) enthalten sind.

13. Zusammensetzung gemäss Anspruch 12, dadurch gekennzeichnet, dass 10 bis 60 Gew.-% (a) und 90 bis 40 Gew.-% (b) enthalten sind.

14. Zusammensetzung gemäss Anspruch 1, dadurch gekennzeichnet, dass sie Füllstoffe und/oder Verstärkerfüllstoffe enthält, wobei die Menge zusammen mit der supraleitenden Verbindung höchstens 90 Gew.-% ausmacht, bezogen auf die Zusammensetzung.

15. Zusammensetzung gemäss Anspruch 1, dadurch gekennzeichnet, dass es sich bei der supraleitenden Verbindungen um ein Cuprat mit $K_2NiF_4$-Struktur und der Formel I

$La_{2-x}M_xCuO_{4-\delta}$ (I)

handelt, worin M Ca, Sr oder Ba und x zwischen 0,05 und 1,1 ist, und $\delta$ das Sauerstoffdefizit bedeutet.

16. Zusammensetzung gemäss Anspruch 15, dadurch gekennzeichnet, dass es sich bei der supraleitenden Verbindung um $La_{1,8}Ba_{0,2}CuO_{4-\delta}$ oder $La_{1,8}Sr_{0,2}O_{4-\delta}$ oder $La_{1,8}Ca_{0,2}CuO_{4-\delta}$ handelt.

17. Zusammensetzung gemäss Anspruch 1, dadurch gekennzeichnet, dass es sich bei der supraleitenden Verbindung um einen Kupferperowskit mit Sauerstoffmangel handelt, der Ba, das teilweise durch Ca oder Sr ersetzt sein kann, und ein oder mehrere seltene Erdmetalle enthält.

18. Zusammensetzung gemäss Anspruch 17, dadurch gekennzeichnet, dass die Seltenen Erdmetalle ausgewählt sind aus der Gruppe Y, Eu, La, Sc und Pr.

19. Zusammensetzung gemäss Anspruch 18, dadurch gekennzeichnet, dass die supraleitende Verbindung der Formel II

$M_3Cu_3O_x$ (II)

entspricht, worin x eine Zahl von 6,7-7,3 ist und $M_3$ $Ba_2Y$, $Ba_2Eu$, $Ba_2La$, $Ba_{1,8}La_{1,2}$, BaCaLa, BaCaY, $Ba_2Y_{0,75}Sc_{0,25}$, $Ba_2Eu_{0,75}Sc_{0,25}$, $Ba_2Y_{0,5}La_{0,5}$, $Ba_{1,5}Sr_{0,5}Y$, $Ba_2Eu_{0,9}Pr_{0,1}$, $Ba_2Eu_{0,9}Y_{0,1}$ oder $Ba_2Eu_{0,75}Y_{0,25}$ bedeutet.

20. Zusammensetzung gemäss Anspruch 1, dadurch gekennzeichnet, dass die supraleitende Verbindung der Formel $Ba_2YCu_3F_2O_y$ entspricht, worin y einem Wert entspricht, dass $T_c \geqq 155$ K ist.

21. Zusammensetzung gemäss Anspruch 1, dadurch gekennzeichnet, dass die supraleitende Verbindung $Ba_{0,6}K_{0,4}BiO_3$, $Bi_2Sr_2CaCu_2O_8$, $BiSrCaCu_2O_x$, ein Bi-Al-Ca-Sr-Cu-O-Multiphasen-System, $Tl_1Ca_2Ba_2Cu_3O_x$ $Tl_2Ca_2Ba_2Cu_3O_x$ oder $Tl_2Ba_2CaCu_2O_8$ darstellt.

22. Zusammensetzung gemäss Anspruch 1, dadurch gekennzeichnet, dass die supraleitende Verbindung ein feinteiliges Material ist.

23. Zusammensetzung gemäss Anspruch 22, dadurch gekennzeichnet, dass die supraleitende Verbindung eine mittlere Korngrösse von bis zu 500 $\mu$m hat.

24. Geformte Gegenstände aus einer Zusammensetzung gemäss Anspruch 1.

25. Verwendung einer Zusammensetzung gemäss Anspruch 1 zur Herstellung geformter Gegenstände für die Abschirmung von statischen Magnetfeldern und zur Uebertragung von elektrischen bzw. magnetischen Kräften.

26. Verwendung einer strahlungshärtbaren Zusammensetzung gemäss Anspruch 1 zur Herstellung von Beschichtungen, Reliefabbildungen oder Verklebungen mittels Strahlungshärtung und gegebenenfalls thermischer Nachhärtung.